# EUROPEAN PATENT APPLICATION

(11) **EP 3 745 456 A1**
(43) Date of publication of application: **02.12.2020**
(21) Application number: 19176847.2
(22) Date of filing: 27.05.2019
(51) Int. Cl.: H01L 23/498, H01G 4/012, H01G 4/30, H01G 4/40

(54) **DECOUPLING CAPACITOR LAYERS PERPENDICULARLY MOUNTED BETWEEN SEMICONDUCTOR CHIP AND SUBSTRATE**

(71) Applicant: Künzer, Jens, 71034 Böblingen (DE)
(72) Inventor: Künzer, Jens, 71034 Böblingen (DE); Gentner, Thomas, 71034 Böblingen (DE)

(57) **Abstract**

A method and apparatus for a multi layer ceramic decoupling capacitor with low parasitic inductance and resistance and without blocking routing space in the semiconductor chip carrier package is to mount a multi terminal ceramic capacitor **600** inside a cavity of the substrate **604** with the metal layer of the capacitor mounted perpendicularly to the silicon chip die **601.** With this layer orientation power and signals can be delivered through the capacitor and therefor substitutes the blocked routing space of the cavity.

## Description

### Field of the Invention

The present invention relates to a multi layer ceramic capacitor and semiconductor chip carrier package system, more particularly a capacitor embedded into substrate and attached to a semiconductor chip.

### Background

A change in switching activity of logic gates in a semiconductor device causes noise on power and ground lines. The power and ground noise leads to performance degradation.

The power and ground noise is commonly reduced by the employment of decoupling capacitors. The ideal connection between the semiconductor device and the decoupling capacitor is without any resistance and inductance. In an actual package this connection is typically as short as possible to reduce parasitic effects that cause unwanted resistance and inductance.

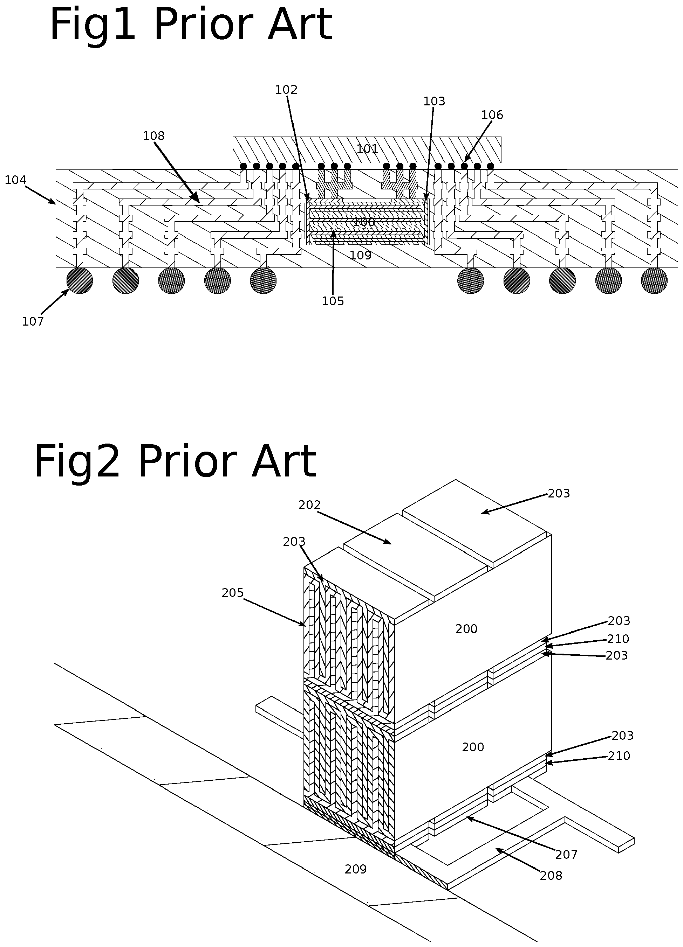

There are established methods to embed electronic parts into the substrate of a semiconductor chip package (Fig1). The substrate **104** of such a package contains wires for power, ground and data signals **108.** Near the semiconductor chip there is often a very high wire congestion. When embedding a decoupling capacitor **100** near the semiconductor chip, the required cavity blocks valuable routing space **109** for many wires.

A multi layer ceramic capacitor (Fig2) have two poles **202** and **203**. Each pole comprising a plurality of conducting layers. The layers of both poles are isolated by dielectric layers **205**. Each pole can have a plurality of terminals that connect to the outside. The advantage of multiple terminals is also to reduce parasitic effects that cause unwanted resistance and inductance.

### Summary of the Invention

It is an object of this invention to reduce the parasitic inductance and resistance of decoupling capacitors and substitute the blocked routing space in the substrate. An additional object of the invention is to connect two power networks and signal layers of different grid size or pin pitch.

A decoupling capacitor embedded into the substrate. The capacitor is connected to silicon chip and to substrate. The capacitor has a dense array of terminals on the side facing the silicon chip. The sides facing the substrate have terminals with a lower pin pitch or at least two terminals. The multiple terminals on the silicon chip side as well as the short distance to the silicon chip both have the advantage to reduce parasitic effects and both lower the unwanted resistance and inductance.

The capacitor layers are perpendicular to the silicon chip die surface. So current can flow from the substrate (supply side) through the capacitor plates of one pole to the silicon chip (load side). And the return current can flow in opposite direction through the capacitor plates of the other pole. This connection is a substitute for the power network that the capacitor blocks in the substrate routing space.

The capacitor may have a layer that includes signal wires. These wires are metal shapes on some of the metal layer of the capacitor and is isolated from both poles. They connect a dedicated signal terminal on silicon chip facing side and a dedicated signal terminal on the substrate facing side. These connections can substitute blocked routing space for data signals and differential signal pairs.

### Brief description of drawings

**Fig.1** is a cross-section view of a prior art substrate **104** with embedded decoupling capacitor **100**. The silicon chip die **101** is mounted on the substrate **104** with solder balls **106**. The positive pole **102** and the negative pole **103** of the decoupling capacitor **100** are electrically connected to the silicon chip die **101**. The metal traces and via interconnects **108** electrically connect the silicon chip die **101** with the solder ball grid array **107**. There is an area **109** at the cavity for the decoupling capacitor **100** that is blocked for metal traces and vertical via interconnects between the solder balls **107** and **106**. The only vertical connection of the decoupling capacitor **100** are the thin terminals of the poles **102** and **103** on the side. The layer of the capacitor **100** are parallel to the layer of the substrate **104** and the surface of the silicon chip die **101**.
**Fig.2** is an isometric view of a prior art stacked capacitors **200** with a cross-section on the side. The multi terminal capacitor **200** has multiple terminals for each pole **202** and **203**. The metal layers of both poles **202** and **203** are isolated by dielectric layers **205**. The terminal pads of the capacitors **200** are mounted with solder **210** to terminal pads of an other capacitor **200**. The capacitors **200** are mounted to the traces **207** and **208** of a printed circuit board **209**. The metal layer of the capacitor **200** are perpendicular to the attached surface of the printed circuit board **209**.

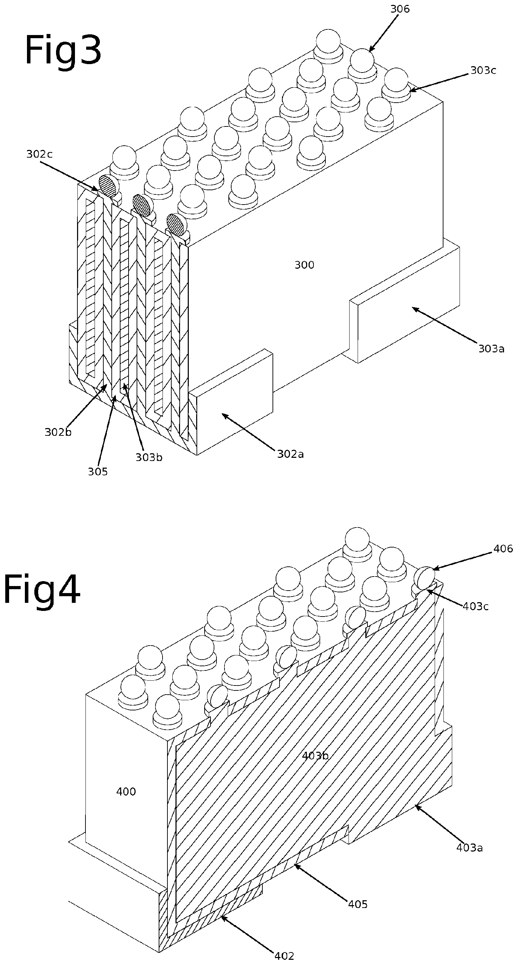

**Fig.3** is an isometric view of an embodiment of the invention. It shows the decoupling capacitor **300** with a cross-section of the side. The capacitor comprises the positive pole metal layers **302b**, the dielectric layers **305** and the negative pole metal layers **303b.** On the top is a solder ball grid array **306**. The solder balls **306** are on a solder pad terminal array for the positive pole **302c** and negative pole **303c**. On the bottom there is a solder pad for the positive pole **302a** and negative pole **303a**. Each positive pole metal layer **302b** electrically connects the positive pole terminal **302a** to several positive pole solder pads **302c**. Each negative pole metal layer **302b** electrically connects the negative pole terminal **302a** to several negative pole solder pads **302c**.
**Fig.4** is an isometric view of an embodiment of the invention. It shows the decoupling capacitor **400** with a cross-section of the front. The metal layer of the negative pole **403b** electrically connects the solder balls **406** at the negative pole solder pads **403c** with the negative pole terminal **403a**. Around the metal layer **403b** there is clearance **405** to the device surface and all opposite pole terminals **402**. There is no clearance **405** at all the terminals of same pole **403a** and **403c**.

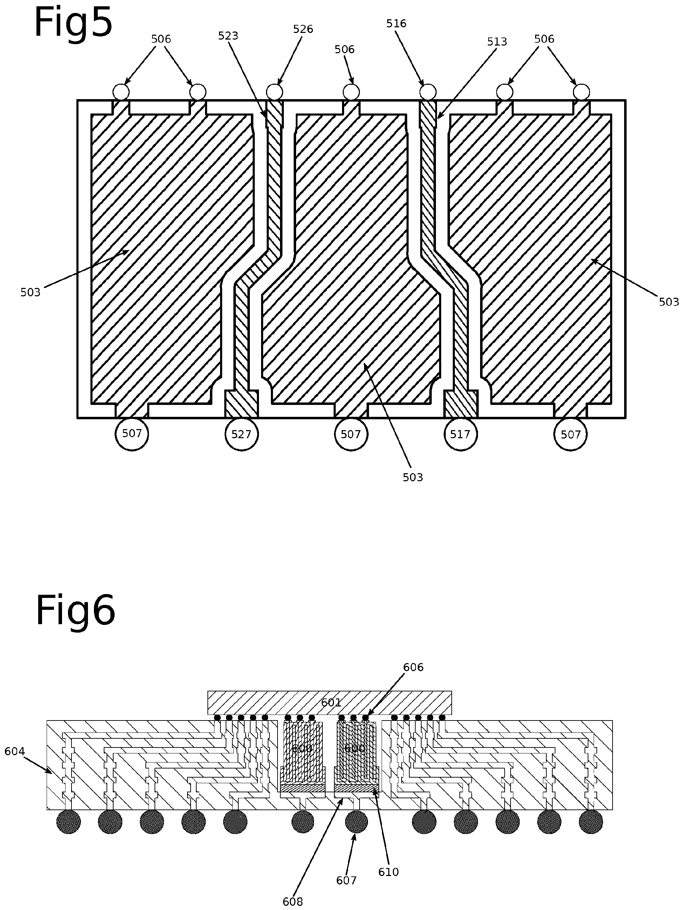

**Fig.5** is a cross-section front view of an embodiment of the invention. It shows the decoupling capacitor with two signal traces **513** and **523** embedded in the metal layer **503**. This embodiment of the decoupling capacitor has solder ball grids arrays **506** and **507** on both sides. The metal layer of one pole **503** is spitted by the signal traces **513** and **523**. Each part of the metal layer **503** electrically connects solder balls **506** and **507** of both sides. The signal paths **513** and **523** are isolated from the metal layer **503**. The signal path **513** electrically connect dedicated solder balls **516** and **517** on opposite sides. The signal path **523** electrically connect dedicated solder balls **526** and **527** on opposite sides.
**Fig.6** is a cross-section view of an embodiment of the invention. It shows the decoupling capacitor **600** embedded into the substrate **604**. In this embodiment two decoupling capacitors **600** are mounted with solder **610** to the metal layer **608** on the substrate **604**. The metal layers of the decoupling capacitors **600** are perpendicular to the surface of the silicon chip die **601**. Power supply current to and from the load can flow along the electrical path: solder ball **607**, traces and vias **608**, the capacitors **600**, solder ball **606** and silicon chip die **601**.

### Detailed Description

An embodiment of the multi-layer ceramic capacitor can be made by printing different type of metallic layers on dielectric sheets:
The base shape of the positive pole layer is rectangular, with clearance to all borders. But on the sides where the positive terminals will be added, there is no clearance and metal layer extends to the border.
The base shape of the negative pole layer is rectangular, with clearance to all borders. But on the sides where the negative terminals will be added, there is no clearance and metal layer extends to the border.
If there are signal terminals the shape of a layer contains signal traces between signal pins on two sides. The signal traces have clearance to the poles and other signal traces.

Multiple of the printed sheets are stacked in interleaving order and laminated. The resulted stack is diced followed by a binder-burnout and then are sintered.
Several of the resulting capacitors are grouped and oriented in a way so that the same front is on one side. This side get metal plated. A photo-resist film is applied and exposed using a mask with the pattern of the terminals. Small terminals like solder ball pads can be extended to connect multiple capacitor layers with same pad. The copper between the terminals etched away. A solder mask can be applied to cover the extended areas of pads. Solder balls and solder paste can be applied either on the cap or later on the substrate. This metal plating of the terminals repeats for all sides of the capacitors that have terminals.

The finished multi-layer ceramic capacitor then embedded into the substrate by the following steps. Some layers of the substrate have holes that form a cavity. The size of the cavity is chosen large enough for one or more capacitors. If the capacitor is an embodiment of the invention without solder balls then solder paste is applied to the solder pads at the substrate inside the cavity. The capacitors are placed inside the cavities of the substrate. Heating up the assembly for a thermal reflow process of the solder. Remaining gaps between capacitor and substrate can be filled with an underfill adhesive. The surface of the assembly can be polished to levelize the capacitor pins and the substrate surface. An additional substrate layer can be applied.
The plating of the silicon chip facing side of the decoupling capacitor can also be deferred after embedding it into the substrate and be applied in the same plating process together with a substrate layer metal plating or the via metal plating.

The silicon chip with solder balls is attached to the substrate with the embedded capacitors in a flip chip process. A thermal reflow of the solder balls make a permanent electrical joint between the silicon chip and pads of both the capacitor and the substrate.

## Claims

1. A capacitor comprising power supply and load facing sides with a plurality of conductive and dielectric layers in between both sides. The orientation of the layers is perpendicular to the surface of the supply and load.

2. A capacitor as described in claim 1 wherein the supply current flows through the conductor plates between supply terminals and load terminals.

3. A capacitor as described in claim 1 or 2 that has different pin pitch or pin count on supply facing side and load facing side

4. A capacitor as described in claim 1-3, that has am multitude of signal wires going through.

5. A package where a capacitor as described in 1-4 is embedded in a cavity on or inside the substrate.

6. A package where a multitude of capacitors as described in 1-4 form the substrate.

## Amended claims

### Amended claims in accordance with Rule 137(2) EPC.

1. A capacitor comprising positive pole [302] and negative pole [303] separated by dielectric layers [305], wherein each pole comprising a terminal on power supply facing side [302a,303a] and a separate terminal on load facing side [302c,303c] with a plurality of conductive layers [302b, 303b] connecting the terminals of both sides. The orientation of the layers is perpendicular to the surface of the supply and load.

2. A capacitor as described in claim 1 wherein a pole comprises a plurality of conductive layers with a plurality of supply terminals[302a,303a] and a plurality of load terminals[302b, 303b].

3. A capacitor as described in claim 1 or 2 that has different pin pitch or pin count on supply facing side and load facing side

4. A capacitor as described in claim 1-3, that has am multitude of separate signal wires not connected to capacitor major plates going through [523,513].

5. A package where a capacitor[600] as described in 1-4 is embedded in a cavity on or inside the substrate[604].

6. A package where a multitude of capacitors as described in 1-4 form the substrate.
